# EUROPÄISCHE PATENTSCHRIFT

(11) **EP 0 933 682 B1**
(45) Veröffentlichungstag und Bekanntmachung des Hinweises auf die Patenterteilung: **09.08.2006**
(21) Anmeldenummer: 99100913.5
(22) Anmeldetag: 20.01.1999
(51) Int. Cl.: G03F 7/023, C08F 22/40, C08F 222/40

(54) **Strahlungsempfindliche Gemische mit Bindemitteln aus Polymeren mit Einheiten aus N-substituiertem Maleimid**
Radiation-sensitive compositions with binders of polymers comprising N-substituted maleimide units
Compositions photosensibles avec des liants comprenant polymères avec des unités maléimides N-substitués

(30) Priorität: 30.01.1998 DE 19803564
(43) Veröffentlichungstag der Anmeldung: 04.08.1999
(73) Patentinhaber: AGFA-GEVAERT, 2640 Mortsel (BE)
(72) Erfinder: Denzinger, Steffen, Dr. Dipl.-Chem., 55128 Mainz (DE); Elsässer, Andreas, Dr. Dipl.-Chem., 65510 Idstein (DE)

(56) Entgegenhaltungen:
- EP-A- 0 004 287
- EP-A- 0 330 239
- EP-A- 0 410 760
- DE-A- 2 715 435
- JP-A- 50 045 076
- US-A- 4 540 762
- US-A- 4 663 268
- US-A- 5 594 086

## Beschreibung

Die Erfindung betrifft ein positiv oder negativ arbeitendes strahlungsempfindliches Gemisch mit Polymeren sowie einem in Wasser unlöslichen, in wäßrigalkalischer Lösung dagegen löslichen oder zumindest quellbaren Bindemittel und mindestens einer strahlungsempfindlichen Verbindung. Sie betrifft daneben ein Aufzeichnungsmaterial mit einem Träger und einer strahlungsempfindlichen Schicht. Ferner betrifft sie ein Verfahren zur Herstellung von chemikalienbeständigen Reliefaufzeichnungen, bei dem das Aufzeichnungsmaterial bildmäßig belichtet und anschließend mit einer wäßrig-alkalischen Lösung entwickelt wird.

Strahlungsempfindliche, positiv oder negativ-arbeitende Gemische, die nach Bestrahlung mit wäßrig-alkalischen Entwicklern fixiert werden, sind bekannt und für vielfältige Verwendungen beschrieben, beispielsweise zur Herstellung von Kopierschichten auf Flachdruckplatten. Der Begriff "Kopierschicht" wird hier und im folgenden für eine bildmäßig bestrahlte und entwickelte, ggf. auch eingebrannte, strahlungsempfindliche Schicht gebraucht.

Die Eigenschaften solcher Kopierschichten werden wesentlich vom Bindemittel bestimmt, besonders weil es den größten Anteil am Gesamtgewicht aller nichtflüchtigen Bestandteile des strahlungs- bzw. lichtempfindlichen Gemisches ausmacht. Als Bindemittel für Positiv-Kopierschichten werden meist Phenol/Formaldehyd- oder Kresol/Formaldehyd-Kondensationsprodukte vom Novalaktyp eingesetzt, während für Negativ-Kopierschichten auf der Basis von Diazoniumsalzpolykondensaten häufig substituierte Polyvinylbutyrale verwendet werden. In Schichten auf Photopolymerbasis werden dagegen häufig Acrylatcopolymere mit geeigneter Acidität benutzt.

Die Eigenschaften der bekannten Positiv- und Negativ-Kopierschichten sind jedoch nicht für alle Anwendungen optimal. Bei Flachdruckplatten ist die Schicht in vielen Fällen nicht ausreichend stabil, um eine hohe Druckauflage zu erreichen.

Darüber hinaus sind die Kopierschichten der Druckplatten oftmals nicht widerstandsfähig genug gegenüber Wasch- und Reinigungsmitteln. Vor allem beim Drucken von Positiv-Kopierschichten mit Druckfarben, die im UV-Licht aushärten, werden Auswaschmittel eingesetzt, die einen hohen Gehalt an organischen Lösemitteln (wie Ethern, Estern oder Ketonen) aufweisen oder sogar vollständig auf der Basis organischer Lösemittel formuliert sind. Die Auswaschmittel können die Kopierschicht stark schädigen. Sind Novolake als Bindemittel vorhanden, ist es unerläßlich, die Kopierschicht bei Temperaturen über 200 °C thermisch zu härten, bevor mit den vorgenannten Farben gedruckt wird oder wenn eine Auflagenhöhe von mehr als etwa 100.000 Drucken erreicht werden soll.

Negativ-Kopierschichten auf Diazoniumpolykondensatbasis mit Polyvinylbutyral-Bindemittel zeigen zwar eine deutlich bessere Stabilität gegen Lösemittel als Positiv-Kopierschichten; die Stabilität gegen Isopropanol-Angriffe und ähnliche Feuchtmittelzusätze ist aber meist unzureichend. Ferner ist ein vergleichsweise hoher Anteil von organischen Lösemitteln im Entwickler nötig, um eine befriedigende Entschichtung zu erzielen.

In Negativ-Kopierschichten auf Photopolymerbasis zeigen die üblichen Bindemittel eine zu geringe Härte, um eine optimale Druckauflagenleistung zu erzielen.

Es wurden bereits verschiedene Bindemittel mit einem verbesserten Eigenschaftsprofil vorgeschlagen. So sind als alkalilösliche Bindemittel Phenolharze auf Naphtholbasis, Homo- und Copolymere von Vinylphenolen (DE-A 23 22 230 = US-A 3 869 292, DE-A 34 06 927 = US-A 4 678 737), Homo- und Copolymere von Hydroxyphenyl-(meth)acrylaten (JP-A 51-36129), Dihydroxyphenyl-(meth)acrylaten, Hydroxynaphthyl-(meth)acrylaten, Hydroxybenzyl-(meth)acrylaten, Hydroxyphenyl-(meth)acrylamiden (JP-A 50-55406), Hydroxybenzyl-(meth)acrylamiden (DE-A 38 20 699 = US-A 5 068 163) oder Hydroxynaphthyl-(meth)acrylamiden, sowie Copolymere von Hydroxyphenylmaleimiden (EP-A 0 187 517) beschrieben. Bekannt als alkalilösliche Bindemittel in strahlungsempfindlichen Gemischen sind auch Homo- und Copolymere mit Halogenmethyleinheiten sowie Homo- und Copolymere aus Monomeren mit N-H-aciden Gruppen, beispielsweise aus N-Methacryl-sulfonamiden (DE-A 37 42 387) oder aus Sulfamoylphenyl-(meth)acrylaten oder N-Sulfamoylphenyl-(meth)acrylamiden (EP-A 0 330 239 und EP-A 0 544 264).

Mit Ausnahme der genannten Polymere mit Einheiten aus Hydroxyphenylacrylamiden oder mit Einheiten, die N-H-acide Gruppen enthalten, hat keines der bekannten Bindemittel bislang eine praktische Anwendung gefunden. Die Gründe hierfür sind schlechtes Entwicklungsverhalten, zu hoher Entwicklerverbrauch, Beeinträchtigung des Belichtungskontrastes und aufwendige Herstellung der Monomere. Gegen Reinigungs- und Feuchtmittel auf Lösemittelbasis sind auch Bindemittel mit Hydroxyphenylacrylamideinheiten nicht resistent genug. Bindemittel mit N-H-aciden Gruppen sind selbst nach einer thermischen Behandlung nicht ausreichend stabil, um eine hohe Druckauflage zuzulassen.

Es bestand daher die Aufgabe, ein Polymer bereitzustellen, das als Bindemittel in einem strahlungsempfindlichen Gemisch eingesetzt werden kann. Das damit hergestellte Aufzeichnungsmaterial soll gute Verarbeitungseigenschaften aufweisen. Die daraus resultierenden Flachdruckplatten sollen hohe Druckauflagen erzielen und resistent sein gegen Reinigungschemikalien.

Gelöst wird die Aufgabe durch die Verwendung eines Polymers in den Gemischen gemäß Anspruch 1, das Einheiten aus N-(4-Sulfamoylphenyl)-maleimid enthält. Gegenstand der Erfindung ist demgemäß ein Homo- oder Copolymer, das Einheiten der Formel I enthält 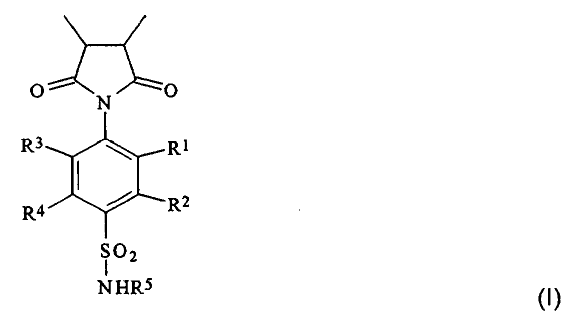 worin
- R¹, R², R³, und R⁴: gleich oder verschieden sind und ein Wasserstoff- oder Halogenatom, eine Hydroxy-, Alkoxy-, Alkyl- oder Arylgruppe, eine unsubstituierte oder substituierte Alkyl- oder Arylgruppe bedeuten und
- R⁵: ein Wasserstoffatom, eine Alkyl- oder Alkanoylgruppe, eine Gruppe der Formel C(=NH)-NH-R¹ oder einen iso- oder heterocyclischen, gesättigten oder ungesättigten, unsubstituierten oder substituierten Rest mit 1 bis 20 C-Atomen darstellt.

Die isocyclischen oder heterocyclischen Reste R⁵ können auch mehrere (in der Regel zwei bis drei) kondensierte oder nicht-kondensierte Ringe enthalten; bevorzugt sind jedoch mono- und bicyclische Reste. Die Heteroatome in den heterocyclischen Resten sind vorzugsweise Sauerstoff-, Schwefel- und/oder Stickstoffatome. Beispiele für heterocyclische Reste mit einem Ring sind Thiazol-2-yl, Pyridin-2-, -3- und -4-yl sowie Pyrimidin-2- und -4-yl. Die nur gegebenenfalls vorhandenen Substituenten in den Alkyl- und Arylresten R¹ bis R⁴ sind insbesondere Halogenatome (speziell Chlor- oder Bromatome) oder Hydroxygruppen, während die Substituenten in dem iso- oder heterocyclischen Rest R⁵ bevorzugt Halogenatome, Hydroxy-, Amino-, Alkylamino-, Dialkylamino-, Alkoxy- oder Alkylgruppen sind.

In einer bevorzugten Ausführungsform stehen R¹, R², R³ und R⁴ für Wasserstoffatome, Hydroxy- oder Alkylgruppen, bevorzugt (C₁-C₂₀)Alkylgruppen. R⁵ ist bevorzugt ein Wasserstoffatom, eine (C₂-C₇)Alkanoylgruppe, insbesondere eine Acetylgruppe, oder der Rest eines monocyclischen Heteroaromaten. R¹, R², R³ und R⁴ sind besonders bevorzugt Wasserstoffatome oder geradkettige oder verzweigte (C₁-C₆)Alkylgruppen, wie Methyl-, Ethyl-, Propyl-, Isopropyl, Butyl-, Isobutyl-, *sec*.-Butyl-, Pentyl-, 3-Methyl-butyl- oder Hexylgruppen.

Die Einheiten der Formel I leiten sich ab von Monomeren der Formel II 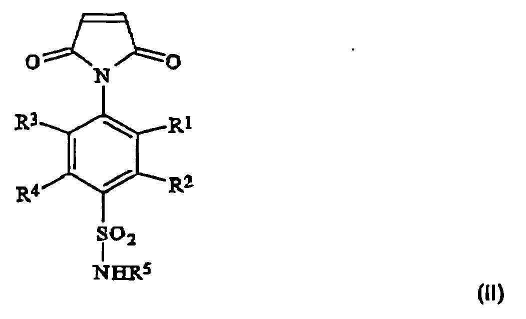 worin R¹ bis R⁵ die oben angegebene Bedeutung haben.

Die N-substituierten Maleimide der Formel II lassen sich nach relativ einfachen Verfahren herstellen, beispielsweise analog zu dem in der WO 96/41841 beschriebenen. Nach diesem Verfahren wird zunächst ein 4-Amino-benzolsulfonamid mit Maleinsäureanhydrid in Lösemitteln wie N,N-Dimethylformamid oder N,N-Dimethylacetamid zu der entsprechenden Maleinamidsäure umgesetzt. Diese Maleinamidsäure wird dann in einem Gemisch aus Acetanhydrid und Natriumacetat zum N'-substituierten N-(4-Aminosulfonyl-benzol)-maleimid umgesetzt. Eine weitere Synthese möglichkeit ist DE 2 715 435 A zu entnehmen.

Neben Einheiten der Fonnel I können die in den erfindungsgemäßen Gemischen eingesetzten Polymeren noch Einheiten aus einem oder mehreren anderen Monomeren enthalten, die zur Einstellung bzw. Anpassung der Eigenschaften des Polymers an spezielle Erfordernisse dienen. Beispiele für "andere Monomere" sind (Meth)acrylsäurealkylester,-arylester oder -(hetero)aralkylester, wie Phenyl-, Benzyl-, Furfuryl- oder Methylmethacrylat, hydroxylgruppenhaltige Ester der (Meth)acrylsäure (wie Hydroxyethyl(meth)acylat). Alkylvinylester oder -ether (wie Vinylacetat oder Vinylmethylether), Styrol oder substituierte Styrole (wie α-Methylstyrol oder Vinyltoluol), (Meth)acrylnitril, unsubstituiertes oder substituiertes (Meth)acrylamid, N-Phenylmaleimid und Vinylamide wie N-Vinyl-pyrrolidon, N-Vinyl-caprolactam oder N-Methyl-N-vinyl-acetamid. Bevorzugt sind Ester der (Meth)acrylsäure. (Meth)acrylnitril, N-substituierte Acrylamide und gegebenenfalls substituierte Styrole. Besonders bevorzugt sind Einheiten, die aromatische Gruppen enthalten, wie Benzyl(meth)acrylat, Benzylmethacrylamid, N-(Meth)acryloylaminomethylphthalimid und gegebenenfalls substituierte Styrole. Die Bezeichnung "(Meth)acrylsäure" steht hier - wie auch im folgenden - für "Acrylsäure und/oder Methacrylsäure". Entsprechendes gilt für (Meth)acrylnitril, (Meth)acrylamid, (Meth) acryloyl-, -(meth)acrylat usw.

Das Molekulargewicht M_{w} des in den erfindungsgemäßen Gemischen eingesetzten Polymers beträgt allgemein 1.000 bis 100.000, bevorzugt 5.000 bis 50.000, besonders bevorzugt 10.000 bis 30.000 (bestimmt mittels GPC anhand eines Polystyrol-Standards). Der Anteil an Einheiten der Formel I in dem Polymer liegt bei 10 bis 90 mol-%, bevorzugt bei 25 bis 65 mol-%, besonders bevorzugt bei 30 bis 50 mol-%.

Die weiteren Einheiten können noch reaktionsfähige Gruppen enthalten, wie das beispielsweise bei Einheiten aus N,N'-Methylen-bis-methacrylamid der Fall ist. Sie können auch thermisch vernetzbaren Gruppen enthalten, beispielsweise aktivierte Gruppen der Formel -CH₂-OR (s. EP-A 184 044). Zu Copolymeren mit reaktiven Seitengruppen führen auch Monomere mit Epoxideinheiten, insbesondere Glycidylmethacrylat, oder Monomere mit seitenständigen verkappten lsocyanateinheiten. Der Anteil dieser reaktiven Monomereinheiten im erfindungsgemäßen Polymer beträgt bis zu 5 mol-%, bevorzugt 1 bis 4 mol-%.

Die Homo- oder Copolymerisation der Monomere gemäß Formel II läßt sich nach Methoden durchführen, die dem Fachmann an sich bekannt sind, beispielsweise in Gegenwart eines Polymerisationsinitiators, wie Azo-bis-isobutyronitril oder Dibenzoylperoxid, in organischen Lösemitteln bei erhöhten Temperaturen während eines Zeitraums von 1 bis 20 Stunden. Daneben ist aber auch eine Suspensions-, Emulsions-, Fällungs- oder Massepolymerisation möglich, die auch durch Strahlung, Hitze oder ionische Initiatoren ausgelöst werden kann.

Gegenstand der Erfindung ist ein positiv oder negativ arbeitendes strahlungsempfindliches Gemisch gemäß Anspruch 1, das a) ein in Wasser unlösliches, in wäßrigalkalischer Lösung dagegen lösliches oder zumindest quellbares Bindemittel und b) mindestens eine strahlungsempfindliche Verbindung enthält. Es ist dadurch gekennzeichnet, daß das Bindemittel das vorstehend beschriebene Polymer umfaßt oder daraus besteht. Der Anteil des erfindungsgemäßen Polymers beträgt 10 bis 95 Gew.-%, bevorzugt 30 bis 80 Gew.-%, jeweils bezogen auf das Gesamtgewicht der nichtflüchtigen Bestandteile des Gemisches.

Als strahlungsempfindliche Verbindung für positiv arbeitende Gemische, die für eine Belichtung im Wellenlängenbereich von 350 bis 450 nm bestimmt sind, kann eine 1,2-Chinondiazid-Verbindung gewählt werden. Weiterhin eignen sich dafür Kombinationen von Verbindungen, die bei Bestrahlung eine starke Säure bilden, und Verbindungen, die mindestens eine durch eine Säure spaltbare C-O-C-Bindung enthalten. Gemische, die mit IR-Strahlung im Bereich von 750 bis 1100 nm belichtbar sein sollen, enthalten als thermischen Sensibilisator beispielsweise Ruß bei Breitbandsensibilisierung oder Methinfarbstoffe als spektrale Sensibilisatoren.

Für negativ arbeitende Gemische kann als strahlungsempfindliche Komponente entweder ein Diazoniumpolykondensationsprodukt oder ein radikalisch polymerisierbares System, bestehend aus Photoinitiatoren und ethylenisch ungesättigten Verbindungen, die radikalisch polymerisierbar sind, oder eine Kombination dieser Komponenten, eingesetzt werden.

Als strahlungsempfindliche Komponenten eignen sich auch positiv-arbeitende Photohalbleiter oder ein Gemisch von Photohalbleitern und Sensibilisatoren.

Die 1,2-Chinondiazide sind bevorzugt 1,2-Naphthochinon-2-diazid-4- oder -5-sulfonsäureester oder -amide. Davon wiederum sind die Ester aus 1,2-Naphtochinon-2-diazid-4- oder -5-sulfonsäure und 2,5-Dihydroxy-benzophenon, 2,3,4-Trihydroxybenzophenon, 2,3,4-Trihydroxy-4'-methyl-benzophenon, 2,3,4-Trihydroxy-4'-methoxy-benzophenon, 2,3,4,4'-Tetrahydroxy-benzophenon, 2,3,4,2',4'-Pentahydroxy-benzophenon, 5,5'-Dialkanoyl-2,3,4,2',3',4'-hexahydroxy-diphenylmethan (speziell 5,5'-Diacetyl-2,3,4,2',3',4'-hexahydroxy-diphenylmethan) oder 5,5'-Dibenzoyl-2,3,4,2',3',4'-hexahydroxy-diphenylmethan bevorzugt. Die Polyhydroxyverbindungen sind dabei in der Regel partiell verestert. Der Anteil der 1,2-Chinondiazidverbindung(en) beträgt allgemein 3 bis 50 Gew.-%, bevorzugt 7 bis 35 Gew.-%, bezogen auf das Gesamtgewicht der nichtflüchtigen Bestandteile des Gemisches.

Es ist auch möglich, die 1,2-Chinondiazidverbindungen in Form ihrer Ester oder Amide mit den erfindungsgemäßen Polymeren einzusetzen, wenn diese umsetzbare Hydroxy- oder Aminogruppen enthalten. Die Veresterung/Amidierung der entsprechenden 1,2-Chinondiazidsulfon- oder -carbonsäuren mit den Hydroxy- und/oder Aminogruppen der zugrunde liegenden Polymere erfolgt dabei nach Verfahren, die dem Fachmann bekannt sind.

Besonders geeignete säurespaltbare Verbindungen sind
A) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,
B) Oligomer- und Polymerverbindungen mit wiederkehrenden Acetal- und/oder Ketalgruppierungen in der Hauptkette und
C) Verbindungen mit mindestens einer Enolether- oder N-Acyliminocarbonatgruppierung.

Durch Säure spaltbare Verbindungen des Typs A) als Komponenten strahlungsempfindlicher Gemische sind in der EP-A 0 022 571 ausführlich beschrieben. Gemische, die Verbindungen des Typs B) enthalten, sind in der DE-C 23 06 248 und der DE-C 27 18 254 offenbart. Verbindungen des Typs C) sind aus der EP-A 0 006 626 und 0 006 627 bekannt. Der Anteil der spaltbaren Verbindung beträgt allgemein 5 bis 70 Gew.-%, bevorzugt 5 bis 40 Gew.-%.

Als strahlungsempfindliche Komponente, die beim Bestrahlen vorzugsweise starke Säure bildet bzw. abspaltet, ist eine große Anzahl von bekannten Verbindungen und Mischungen, wie Phosphonium-, Sulfonium- und Iodoniumsalzen, Halogenverbindungen und Organometall-Organohalogen-Kombinationen geeignet.

Die genannten Phosphonium-, Sulfonium- und lodoniumverbindungen werden in der Regel eingesetzt in Form ihrer in organischen Lösemitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mindestens einem Halogenatom an einem Kohlenstoffatom oder an einem aromatischen Ring brauchbar. Von diesen Verbindungen sind die s-Triazinderivate mit Halogenmethylgruppen, insbesondere Trichlormethylgruppen, und einem aromatischen bzw. ungesättigten Substituenten im Triazin-Kem gemäß DE-C 27 18 259 (= US-A 4 189 323) bevorzugt. Ebenso geeignet sind 2-Trihalogenmethyl-[1,3,4]oxadiazole. Die Wirkung dieser halogenhaltigen Verbindungen kann auch durch bekannte Sensibilisatoren spektral beeinflußt und gesteigert werden.

Die Menge des Starters kann je nach seiner chemischen Natur und der Zusammensetzung der Schicht ebenfalls sehr verschieden sein. Günstige Ergebnisse erzielt man, wenn der Anteil des Starters etwa 0,1 bis 10 Gew.-%, bevorzugt 0,2 bis 5 Gew.-%, beträgt, jeweils bezogen auf das Gesamtgewicht der nichtflüchtigen Anteile der Schicht. Besonders für Kopierschichten von Dicken über 0,01 mm empfiehlt es sich, relativ wenig Säurespender zu verwenden.

Um eine Sensibilisierung gegenüber IR-Strahlung zu erhalten, eignen sich Rußdispersionen im oben beschriebenen polymeren Bindemittel. Unter IR-sensitiv soll hier- wie allgemein üblich- verstanden werden, daß das Gemisch bzw. die daraus gebildete Schicht für Strahlung mit einer Wellenlänge von 700 bis 1100 nm sensitiv ist. Rußpigmente eignen sich deshalb besonders als IR-absorbierende Komponente, da sie über einen breiten IR-Wellenlängenbereich absorbieren. Es können aber auch andere Verbindungen, die im IR-Bereich absorbieren, wie geeignet substituierte Phthalocyanine (z.B. PRO-JET 830 oder Projet 950 NP der Firma Zeneca) oder Methinfarbstoffe, zur IR-Sensibilisierung benutzt werden. Für IR-Strahlung sensitive Gemische sind aus den DE-A 197 12 323, DE-A 197 39 302, EP-A 0 625 728 und 0 780 239 bekannt.

Geeignete Diazoniumpolykondensationsprodukte sind dem Fachmann bekannt. Sie können auf übliche Weise durch Kondensation eines Diazomonomers (EP-A 0 152 819) mit einem Kondensationsmittel, wie Formaldehyd, Acetaldehyd, Propionaldehyd, Butyraldehyd, Isobutyraldehyd oder Benzaldehyd oder Aldehyden mit aciden Einheiten, wie *para*-Formyl-benzoesäure, hergestellt werden. Weiterhin lassen sich Mischkondensate verwenden, die außer den Diazoniumverbindungen noch andere, nicht lichtempfindliche Einheiten enthalten, die von kondensationsfähigen Verbindungen abgeleitet sind, insbesondere von aromatischen Aminen, Phenolen, Phenolethern, aromatischen Thioethern, aromatischen Kohlenwasserstoffen, aromatischen Heterocyclen oder organischen Säureamiden, die auch mit aciden Einheiten substituiert sein können. Besonders bevorzugte Diazoniumpolykondensationsprodukte sind Umsetzungsprodukte von Diphenylamin-4-diazoniumsalzen, die gegebenenfalls eine Methoxygruppe in dem die Diazogruppe tragenden Phenylrest enthalten, mit Formaldehyd oder 4,4'-Bis-methoxymethyl-diphenylether. Als Anion dieser Diazoharze eignen sich besonders aromatische Sulfonate, wie Toluol-4-sulfonat oder Mesitylensulfonat. Der Anteil an Diazoniumpolykondensationsprodukt(en) beträgt vorzugsweise 3 bis 60 Gew.-%, bezogen auf das Gesamtgewicht der nichtflüchtigen Bestandteile des lichtempfindlichen Gemisches.

Die negativ arbeitende lichtempfindliche Komponente kann auch ein radikalisch polymerisierbares System sein. Dieses setzt sich zusammen aus Photoinitiatoren, die im Bereich von 300 bis 1100 nm absorbieren, und radikalisch polymerisierbaren ethylenisch ungesättigten Bestandteilen. Als Photoinitiatoren eignen sich beispielsweise Grundkörper bzw. Derivate von Acetophenon, Benzophenon, Trichlormethyl-[1,3,5]triazin, Benzoin, Benzoinethern, Benzoinketalen, Xanthon, Thioxanthon, Acridin, Porphyrin oder Hexaarylbisimidazol. Diese können in Verbindung mit einem unter Umständen substituierten Metallocen eingesetzt werden (EP-A 0 364 735). Der radikalisch polymerisierbare Bestandteil ist ein Acryl- oder Methacrylsäurederivat mit einer oder mehreren ungesättigten Gruppen, vorzugsweise Ester der (Meth)acrylsäure in Form von Monomeren, Oligomeren oder Präpolymeren. Er kann in fester oder in flüssiger Form vorliegen, wobei feste und zähflüssige Formen bevorzugt sind. Zu den Verbindungen, die als Monomer geeignet sind, zählen beispielsweise Trimethylolpropantri(meth)acrylat, Pentaerythrithexa (meth)acrylat, Dipentaerythritpenta(meth)acrylat, Dipentaerithrithexa(meth)acrylat, Pentaerythrittetra(meth)acrylat, 1,1,1,3,3,3-Hexamethylol-propan-tetra(meth)acrylat (auch bezeichnet als "Ditrimethylolpropan-tetra(meth)acrylat"), Diethylenglykol-di(meth)acrylat, Triethylenglykol-di(meth)acrylat oder Tetraethylenglykol-di(meth)acrylat. Besonders bevorzugte radikalisch polymerisierbare, ethylenisch ungesättigte Verbindungen sind Acrylsäureester oder Alkylacrylsäureester mit mindestens einer bei Belichtung in Gegenwart des Initiators photooxydierbaren Gruppe z. B. einer Amino-, Harnstoff- Thio- oder Enolgruppe sowie die Umsetzungsprodukte von Triethanolamin oder N,N'-(2-hydroxy-ethyl)-piperidin mit Isocyanatoethyl-methacrylat oder von Triethanolamin und 2,2,4-Trimethyl-hexamethylendiisocyanat mit Glycidylacrylat. Geeignete Oligomere bzw. Präpolymere sind (Meth)acrylat-Gruppen enthaltende Polyurethane, Epoxidharze oder Polyester, daneben auch ungesättigte Polyesterharze.

Der Anteil der Photoinitiatoren beträgt bevorzugt 0,5 bis 20 Gew.-%, der der radikalisch polymerisierbaren Verbindung 5 bis 80 Gew.-%, jeweils bezogen auf Gesamtgewicht der nichtflüchtigen Bestandteile des lichtempfindlichen Gemisches.

Eine Kombination der Diazoniumpolykondensationsprodukte mit einem radikalisch polymerisierbaren System bestehend aus Photoinitiatoren und ethylenisch ungesättigten Verbindungen, die radikalisch polymerisierbar sind, kann für bestimmte Anwendungen Vorteile bringen. Solche Hybridsysteme enthalten vorzugsweise 1 bis 50 Gew.-% Diazoniumpolykondensationsprodukte, 0,5 bis 20 Gew.-% Photoinitiatoren sowie 5 bis 80 Gew.-% der radikalisch polymerisierbare Verbindungen.

Die erfindungsgemäßen Polymere eignen sich auch in elektrophotographischen Schichten wie sie beispielsweise in den EP-A 0 157 241 und 0 324 180 beschrieben sind. Als Photohalbleiter können z. B. Derivate des Oxadiazols oder geeignet substituierte Triphenylene eingesetzt werden.

Zusätzlich können noch zahlreiche andere Oligomere und Polymere mitverwendet werden, z.B. Phenolharze vom Novolaktyp oder Vinylpolymere wie Polyvinylacetale, Poly(meth)acrylate, Polyvinylether und Polyvinylpyrrolidone, die gegebenenfalls selbst durch Comonomere modifiziert sind.

Zur Darstellung eines bildmäßigen Farbkontrastes unmittelbar nach der Belichtung enthalten die Schichten darüber hinaus noch eine Kombination von Indikatorfarbstoffen und strahlungsempfindlichen Komponenten, die beim Belichten starke Säuren bilden, wie oben beschrieben.

Die Menge des photochemischen Säurespenders kann, je nach seiner chemischen Natur und der Zusammensetzung der Schicht, ebenfalls sehr verschieden sein. Günstige Ergebnisse werden erhalten mit etwa 0,1 bis zu 10 Gew.-%, bezogen auf den Gesamtgewicht der nichtflüchtigen Bestandteile der Schicht.

Als Indikatorfarbstoffe haben sich kationische Farbstoffe wie Triphenylmethanfarbstoffe insbesondere in der Form ihrer Carbinolbasen und die Methinfarbstoffe besonders bewährt.

Ferner können dem strahlungsempfindlichen Gemisch noch lösliche oder auch feinteilige, dispergierbare Farbstoffe sowie UV-Absorber, Tenside, Polyglykolderivate und Pigmente zugesetzt werden. Die günstigsten Mengenverhältnisse der Komponenten lassen sich im Einzelfall durch Vorversuche leicht ermitteln.

Die Erfindung betrifft auch ein strahlungsempfindliches Aufzeichnungsmaterial aus einem Schichtträger und einer strahlungsempfindlichen Schicht, die aus dem erfindungsgemäßen Gemisch besteht.

Zur Beschichtung eines geeigneten Schichtträgers werden die Gemische im allgemeinen in einem Lösemittel gelöst. Die Wahl der Lösemittel ist auf das vorgesehene Beschichtungsverfahren, die Schichtdicke und die Trocknungsbedingungen abzustimmen. Geeignete Lösemittel für das erfindungsgemäße Gemisch sind insbesondere stark polare Lösemittel wie Dimethylsulfoxid, Tetramethylensulfon (Sulfolan), N-Methylpyrrolidon, N-Hydroxyethyl-pyrrolidon, N,N-Dimethylformamid, N,N-Dimethylacetamid, γ-Butyrolacton, Aceto- oder Butyronitril, 2-Nitro-propan oder Nitromethan, Ethylen- oder Propylencarbonat. Bevorzugt werden diese Lösemittel im Gemisch mit Ketonen (wie Aceton und Methylethylketon), chlorierten Kohlenwasserstoffen (wie Trichlorethylen und 1,1,1-Trichlorethan), Alkoholen (wie Methanol, Ethanol oder Propanol), Ethern (wie Tetrahydrofuran), Alkoholethem (wie Ethylen- oder Propylenglykolmonomethylether) und Estern (wie Methyl- oder Ethylacetat, Ethylen- oder Propylenglykolmonomethyletheracetat) verwendet. Prinzipiell sind alle Lösemittel oder Lösemittelmischungen verwendbar, die mit den Schichtkomponenten nicht irreversibel reagieren.

Als Schichtträger für Schichtdicken unter ca. 10 µm werden meist Metalle verwendet. Für Offsetdruckplatten eignet sich walzblankes, mechanisch und/oder elektrochemisch aufgerauhtes und gegebenenfalls anodisiertes Aluminium. Das Trägermaterial kann zudem noch chemisch vorbehandelt sein, z.B. mit Polymeren oder Polykondensaten, die Einheiten mit Phosphon-, Carbon- oder Sulfonsäuregruppen aufweisen und daneben noch Einheiten mit basischen Gruppen, z.B. Aminogruppen, enthalten können. Zur Vorbehandlung eignen sich ferner Silikate, Phosphate, Fluoride oder Fluorokomplexe. Auch Kombinationen solcher Vorbehandlungen sind möglich.

Die Beschichtung des Schichtträgers erfolgt in bekannter Weise durch Aufschleudern, Sprühen, Tauchen, Walzen, mittels Breitschlitzdüsen, Rakeln oder durch Gießer-Antrag.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Belichtung bzw. Bestrahlung ist in dieser Beschreibung die Einwirkung aktinischer elektromagnetischer Strahlung in Wellenlängenbereichen unterhalb etwa 1100 nm zu verstehen. Alle in diesem Wellenlängenbereich emittierenden Strahlungsquellen sind prinzipiell geeignet.

Vorteilhaft sind auch Laserbestrahlungsgeräte, insbesondere automatische Verarbeitungsanlagen, die als Strahlungsquelle z.B. einen Argon- einen Krypton-Ionen-Laser, einen frequenzverdoppelten Nd-YAG-Laser oder eine Laser-Diode enthalten.

Die Bestrahlung kann ferner mit Elektronenstrahlen erfolgen. In diesem Fall können auch im üblichen Sinne nicht lichtempfindliche, säurebildende Verbindungen als Initiatoren der Solubilisierungsreaktion eingesetzt werden, z.B. halogenierte aromatische Verbindungen oder halogenierte polymere Kohlenwasserstoffe. Auch Röntgenstrahlen eignen sich zur Bilderzeugung.

Die bildmäßig belichtete oder bestrahlte Schicht kann in bekannter Weise mit praktisch den gleichen Entwicklern, wie sie für handelsübliche Schichten und Kopierlacke bekannt sind, entwickelt werden. Die erfindungsgemäßen Aufzeichnungsmaterialien können auf spezielle Entwickler und programmierte Sprühentwicklungsgeräte abgestimmt werden. Die wäßrigen Entwicklerlösungen können zum Beispiel Alkaliphosphate, -silikate oder - hydroxide und ferner Netzmittel sowie gegebenenfalls kleinere Anteile organischer Lösemittel enthalten. In bestimmten Fällen sind auch Lösemittel/Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Zur weiteren Verfestigung der Kopierschicht kann das erfindungsgemäße Aufzeichnungsmaterial nach bildmäßiger Belichtung und Entwicklung mit einer wäßrig-alkalischen Lösung - gegebenenfalls mit einem hydrophilen Schutzfilm überzogen - auf erhöhte Temperatur erwärmt oder nachbelichtet werden. Bei diesem als "Einbrennen" bekannten Verfahren wird das entwickelte Aufzeichnungsmaterial in der Regel für 0,5 bis 60 Minuten auf eine Temperatur von 150 bis 280 °C erwärmt.

Im folgenden werden Beispiele für bevorzugte Ausführungsformen angegeben. In den Beispielen steht Gt für "Gewichtsteil(e)".

### Synthesebeispiel 1 für Monomere gemäß Formel II

1 mol Maleinsäureanhydrid wurde in 150 ml Lösemittel gelöst. Unter Eiskühlung wurde 1 mol des jeweiligen 4-Amino-benzolsulfonamids in 800 ml des Lösemittels zugetropft. Nach beendeter Zugabe wurde ein Tag bei Raumtemperatur gerührt und dann die Maleinamidsäure in Wasser ausgefällt. Die Maleinamidsäure wurde im Vakuum getrocknet und dann mit 900 ml Acetanhydrid und 50 g Natriumacetat drei Stunden auf 70°C erhitzt. Das substituierte Maleimid wurde in Wasser ausgefällt und im Vakuum getrocknet. Die Ausbeute über beide Stufen betrug zwischen 80 und 95% der Theorie. Nach dieser Vorschrift wurden erhalten:
Monomer 1: 4-Maleimido-benzolsulfonamid, hergestellt aus Maleinsäureanhydrid und Sulfanilamid (= 4-Amino-benzolsulfonamid); (Formel II: R¹= R² = R³= R⁴ = R⁵= H)
¹H-NMR (200 MHz; DMSO-d₆): 7,25 (s; 2H), 7,65 (d; 2H), 8,05 (d; 2H)

| | | |
|---|---|---|
| Elementaranalyse: | C: 47,58 % | (ber.: 47,57 %) |
| | H: 3,14 % | (ber.: 3,17 %) |
| | N: 11,15 % | (ber.: 11,10 %) |

Monomer 2: N-Thiazol-2-yl-4-maleimido-benzolsulfonamid, hergestellt aus Maleinsäureanhydrid und Sulfanilsäure-N-(thiazol-2-yl)-amid (= Sulfathiazol); (Formel II: R¹= R²= R³= R⁴ = H, R⁵= Thiazol-2-yl)
¹H-NMR (200 MHz; DMSO-d₆): 6,85 (d; 1H), 7,25 (s; 2H), 7,30 (d, 1H), 7,95 (d, 2H)

| | | |
|---|---|---|
| Elementaranalyse: | C: 46,28 % | (ber.: 46,38 %) |
| | H: 2,75 % | (ber.: 2,68 %) |
| | N: 12,48 % | (ber.: 12,49 %) |

Monomer 3: N-(4,6-Dimethyl-pyrimidin-2-yl)-4-maleimido-benzolsulfonamid, hergestellt aus Maleinsäureanhydrid und Sulfanilsäure-N-(4,6-dimethylpyrimidin-2-yl)-amid (= Sulfadimidin); (Formel II: R¹= R²= R³= R⁴ = H, R⁵ = 4,6-Dimethyl-pyrimidin-2-yl)
¹H-NMR (200 MHz; DMSO-d₆): 2,30 (s; 6H), 6,75 (s; 1H), 7,25 (s; 2H), 7,55 (d; 2H), 8,10 (d; 2H)

| | | |
|---|---|---|
| Elementaranalyse: | C: 53,54 % | (ber.: 53,58 %) |
| | H: 3,95% | (ber.: 3,91 %) |
| | N: 15,65 % | (ber.: 15,63 %) |

Monomer 4: N-Acetyl-4-maleimido-benzolsulfonamid, hergestellt aus Maleinsäureanhydrid und Sulfacetamid; (Formel II: R¹= R²= R³= R⁴ = H, R⁵ = CO-CH₃)
¹H-NMR (200 MHz; DMSO-d₆):1,95 (s; 3H), 7,25 (s; 2H), 7,65 (d; 2H), 8,00 (d; 2H)

| | | |
|---|---|---|
| Elementaranalyse: | C: 48,81 % | (ber.: 48,93 %) |
| | H: 3,44 % | (ber.: 3,40%) |
| | N: 9,53 % | (ber.: 9,51 %) |

### Synthesebeispiel 2 für Monomere gemäß Formel II

1 mol Maleinsäureanhydrid wurde in 700 ml Lösemittel gelöst. Unter Eiskühlung wurde 1 mol des jeweiligen 4-Amino-benzolsulfonamids portionsweise zugegeben. Nach beendeter Zugabe wurde ein Tag bei Raumtemperatur gerührt. Dann wurden 900 ml Acetanhydrid und 50 g Natriumacetat zugegeben und das Reaktionsgemisch eine Stunde auf 45°C erhitzt. Das substituierte Maleimid wurde in Wasser ausgefällt und im Vakuum getrocknet. Die Ausbeute über beide Stufen betrug zwischen 80 und 95% der Theorie. Nach dieser Vorschrift wurden erhalten:
Monomer 5: 4-Maleimido-2,5-dimethoxy-N-methylbenzolsulfonamid, hergestellt aus Maleinsäureanhydrid und 4-Amino-2,5-dimethoxy-N-methylbenzolsulfonamid); (R¹= R⁴ = OCH₃ ; R² = R³ = H ; R⁵ = CH₃)
¹H-NMR (400 MHz; DMSO-d₆): 3,3 (s; 6H), 3,75 (d; 3H), 7,25 (s; 2H), 7,40 (s,1H, 7,55 (s, 1H)

| | | |
|---|---|---|
| Elementaranalyse: | C: 47,74 % | (ber.: 47,81 %) |
| | H: 4,44 % | (ber.: 4,29%) |
| | N: 8,65 % | (ber.: 8,58 %) |

Monomer 6: 4-Maleimido-sulfaguanidin, hergestellt aus Maleinsäureanhydrid und Sulfaguanidin (R¹= R³ = R² = R⁴ = H, R⁵ = CNH-NH₂)
¹H-NMR (400 MHz; DMSO-d₆): 7,25 (s; 2H), 7,65 (d,2H, 8,15 (d, 2H)

| | | |
|---|---|---|
| Elementaranalyse: | C: 45,20 % | (ber.: 44,21 %) |
| | H: 4,47 % | (ber.: 3,40 %) |
| | N: 19,13 % | (ber.: 19,03 %) |

### Synthesebeispiel für Polymere mit Monomereinheiten gemäß Formel I:

Die Monomeren wurden in einem der oben genannten stark polaren Lösemittel gelöst, so daß eine Lösung mit einem Feststoffgehalt von 25 Gew-% erhalten wurde. Diese wurde auf 80 C erhitzt. Unter Argon-Inertisierung wurden dann 3 mol-% Azo-bis-isobutyronitril, bezogen auf die Gesamtmonomerzusammensetzung, innerhalb 30 Minuten zugegeben. Die Lösungen wurden noch ca. 7 Stunden bei dieser Temperatur gehalten. Mit den Monomeren der Tabelle 1 wurden nach dieser Vorschrift die in Tabelle 2 aufgeführten Polymere erhalten.

**Tabelle 1**

| **Monomer Nr.** | **Chemische Bezeichnung** |
|---|---|
| 1 | 4-Maleimido-benzolsulfonamid |
| 2 | 4-Maleimido-N-thiazol-2-yl-benzolsulfonamid |
| 3 | N-(4,6-Dimethyl-pyrimidin-2-yl)-4-maleimido-benzolsulfonamid |
| 4 | N-Acetyl-4-maleimido-benzolsulfonamid |
| 5 | 4-Maleimido-2,5-dimethoxy-N-methyl-benzolsulfonamid |
| 6 | 4-Maleimido-sulfaguanidin |
| 7 | N-Phthalimidomethyl-methacrylamid |
| 8 | N-(4-Hydroxy-phenyl)-methacrylamid |
| 9 | Styrol |
| 10 | Benzylmethacrylat |
| 11 | (2-Hydroxy-phenyl)-methacrylat |
| 12 | 4-Acryloyfamino-benzolsulfonamid |
| 13 | 4-Hydroxystyrol |
| 14 | N-(3,5-Dimethyl-4-hydroxy-benzyl)-methacrylamid |
| 15 | N-Phenyl-maleimid |

| | |
|---|---|
| Maleimido = (2,5-Dioxo-2,5-dihydro-pyrrol-1-yl) | |

**Tabelle 2**

| Polymer Nr. | Monomer A | Monomer B | Monomer C |
|---|---|---|---|
| 1 | 1 (50) | 9 (50) | |
| 2 | 2 (50) | 9 (50) | |
| 3 | 3 (50) | 9 (50) | |
| 4 | 4 (50) | 9 (50) | |
| 5 | 1 (40) | 7 (60) | |
| 6 | 2 (50) | 7 (50) | |
| 7 | 2 (40) | 7 (60) | |
| 8 | 3 (60) | 7 (40) | |
| 9 | 4 (60) | 7 (40) | |
| 10 | 4 (60) | 10 (40) | |
| 11 | 3 (50) | 10 (50) | |
| 12 | 1 (60) | 11 (40) | |
| 13 | 3 (60) | 11 (40) | |
| 14 | 5 (60) | 15 (25) | 10 (15) |
| 15 | 6 (60) | 7 (40) | |
| 16 | 3 (60) | 15 (30) | 10 (20) |
| 17 | 5 (70) | 7 (30) | |
| 18 | 4 (70) | 10 (30) | |
| 19V | 8 (100) | gemäß JP-A2 51-36129 | |
| 20V | 12 (100) | gemäß EP-A 0330239 | |
| 21 V | 13 (100) | gemäß DE-A 38 20 699 | |
| 22V | 14 (100) | gemäß DE-A 2322230 | |
| 23V | 11 (100) | gemäß JP-A2 50-55406 | |

| | | | |
|---|---|---|---|
| (....) = Anteil des Monomers in mol-% in der Ausgangsmonomerzusammensetzung | | | |

Das mittlere Molekulargewicht M_{w} (bestimmt durch Gel-Permeations-Chromatographie [GPC] anhand eines Polystyrol-Standards) lag bei den Polymeren 1 bis 13 im Bereich von 10.000 bis 30.000, das Molekulargewicht Mₙ im Bereich von 3.000 bis 10.000.

### Beispiel 1

Eine in Salzsäure elektrolytisch aufgerauhte (RZ-Wert nach DIN 4768 5,0 µm), in Schwefelsäure zwischengebeizte und anodisierte (Oxidgewicht 3,5 g/m²) und mit phosphonomethyliertem Polyethylenimin und mit Polyvinylphosphonsäure (entsprechend DE 44 23 140) hydrophilierte Aluminiumfolie der Stärke 300 µm wurde mit folgender Lösung schleuderbeschichtet:

| | |
|---|---|
| 7,8 Gt | Bindemittel (vgl. Tabelle 2), |
| 3,2 Gt | eines Veresterungsproduktes aus 1,5 mol 1,2-Naphthochinon-2-diazid-5-sulfonylchlorid und 1 mol 2,3,4-Trihydroxy-benzophenon, |
| 0,4 Gt | 1,2-Naphthochinon-2-diazid-4-sulfonylchlorid, |
| 0,2 Gt | Victoriareinblau (Color Index No. 44 045), |
| 0,1 Gt | eines Kieselgelfüllstoffs einer mittleren Korngröße von 4 µm und |
| ad 100 Gt | eines Lösemittelgemisches aus Tetrahydrofuran, 1-Methoxy-propan-2-ol und Dimethylsulfoxid (50:35:15) |

und bei 110 °C getrocknet, anschließend 100 s mit einer 5-kW-Metallhalogenidlampe im Abstand von 110 cm durch eine Testvorlage mit Halbtonelementen (Belichtungskeil "BK 02" der Agfa-Gevaert AG) und Rasterelementen (Belichtungskeil "RK 01" der Agfa-Gevaert AG) belichtet und 60 s in einem Entwickler mit folgender Zusammensetzung entwickelt:

| | |
|---|---|
| 0,4 mol/l | Na₂SiO₃ |
| 10 g | Natriumbenzoat |
| 1 g | eines Ethylenoxid/Propylenoxid-Copolymers mit einem Molekulargewicht M_{w} von 1.600 |
| ad 1 l | mit vollentsalztem Wasser ("VE-Wasser"). |

Die Ergebnisse sind in Tabelle 3 zusammengefaßt, wobei die Abkürzungen in den Tabellen folgende Bedeutung haben:
- SG -: Schichtgewicht in g/m²;
- LE -: Lichtempfindlichkeit beurteilt nach der offenen Stufe des Halbtonstufenkeils;
- AV -: Wiedergabe, beurteilt nach der Anzahl der vollständig wiedergegebenen 12 Felder des 60er-Rasters der Testvorlage;
- UV -: Stabilität gegen UV-Farben-Waschmittel, nachdem die belichteten und entwickelten Platten 60 Sekunden lang in einer Küvette einem UV-Farbenwaschmittel auf Alkohol-Glykolether/-ester-Basis (UV-Waschmittel W 936 von Zeller & Gmelin) ausgesetzt und anschließend die Bildschädigungen gravimetrisch beurteilt wurden:
+ = Schichtabtrag geringer 10%; schwacher Angriff;
0 = Schichtabtrag zwischen 10 und 30%; mittlerer Angriff;
- = Schichtabtrag größer 30% starker Angriff oder vollständiger Schichtabtrag
- TD -: Thermisches Vernetzungsverhalten nachdem auf die Platten eine handelsübliche Einbrenngummierung (RC 99 der Agfa-Gevaert AG) bei 250°C in einem Lacktrockenschrank 8 Minuten eingebrannt und die Resistenz der Platten mit N,N-Dimethyl-formamid gegen stark polare Lösemittel geprüft wurde:
+ = schwacher oder kein Angriff;
- = starker Angriff oder vollständiger Schichtabtrag.
- DrA -: Druckauflagen: Von diesen Platten wurden im nicht thermisch gehärteten Zustand Druckauflagentests in einer Bogenoffsetmaschine durchgeführt. Als Waschmittel wurde nach jeweils 10.000 Drucken das UV-Farbenwaschmittel W 936 von Zeller & Gmelin benutzt:
+ = mehr als 70.000 Exemplare,
0 = 20 000 bis 70.000 Exemplare,
- = weniger als 20.000 Exemplare.

**Tabelle 3**

| **Beispiel** | **Polymer** | **SG** | **LE** | **AV** | **TD** | **UV** | **DrA** |
|---|---|---|---|---|---|---|---|
| 1- 1 | 1 | 1,8 | 4 | 1-12 | + | + | + |
| 1- 2 | 2 | 2,0 | 3 | 1-12 | + | + | + |
| 1- 3 | 3 | 2,0 | 4 | 1-12 | + | + | + |
| 1- 4 | 4 | 1,9 | 6 | 1-12 | + | + | + |
| 1- 5 | 5 | 2,3 | 3 | 1-12 | + | + | + |
| 1- 6 | 6 | 1,8 | 5 | 1-12 | + | + | + |
| 1- 7 | 7 | 2,0 | 5 | 1-12 | + | + | + |
| 1- 8 | 8 | 1,8 | 6 | 1-12 | + | + | + |
| 1- 9 | 9 | 1,8 | 5 | 1-12 | + | + | + |
| 1-10 | 10 | 1,9 | 6 | 1-12 | + | + | + |
| 1-11 | 11 | 1,8 | 5 | 1-12 | + | + | + |
| 1-12 | 12 | 2,1 | 4 | 1-12 | + | + | + |
| 1-13 | 10 | 2,0 | 6 | 1-12 | + | + | + |
| 1-14 | 14 | 1,8 | 6 | 1-12 | + | + | + |
| 1-15 | 16 | 2,0 | 5 | 1-12 | + | + | + |
| 1-16 | 17 | 2,1 | 5 | 1-12 | + | + | + |
| 1-17V | 23 | 2,1 | 5 | 1-12 | - | - | - |
| 1-18V | 19 | 2,1 | 5 | 1-12 | - | 0 | 0 |
| 1-19V | 20 | 1,8 | 2 | 1-12 | - | + | + |
| 1-20V | 21 | 2,1 | 5 | 1-12 | + | 0 | 0 |
| 1-21V | 22 | 2,1 | 6 | 1-12 | - | - | - |
| 1-22V | PF-Harz* | 2,2 | 6 | 1-12. | + | - | - |

| | | | | | | | |
|---|---|---|---|---|---|---|---|
| * bedeutet hier und im Folgenden "Kresol-Formaldehyd-Novolak mit einer Hydroxylzahl von 420 nach DIN 53783/53240 und einem mittleren Molekulargewicht nach GPC von 6.000 (Polystyrol-Standard)" | | | | | | | |

Die Ergebnisse zeigen, daß die mit den erfindungsgemäßen Polymeren hergestellten Kopierschichten eine höhere Druckauflage als herkömmliche Positiv-kopierschichten mit Novolaken als Bindemittel oder mit anderen als Positivbindemittel beschriebenen Polyacrylaten zuließen, daß sie bei gleichzeitiger guter Lichtempfindlichkeit stabil gegen UV-Waschmittel sind, und daß sie durch thermische Nachhärtung auch gegen stark polare Lösemittel resistent werden.

### Beispiel 2

Eine in Salpetersäure elektrolytisch aufgerauhte (RZ-Wert nach DIN 4768: 4,5 µm), in Schwefelsäure zwischengebeizte und anodisierte (Oxidgewicht: 3,0 g/m²), mit phosphonomethyliertem Polyethylenimin und mit Polyvinylphosphonsäure (wie in DE-A 44 23 140 beschrieben) hydrophilierte Aluminiumfolie der Stärke 280 µm wurde mit folgender Lösung schleuderbeschichtet:

| | |
|---|---|
| 7,0 Gt | Bindemittel (siehe Tabelle 4), |
| 1,8 Gt | eines Veresterungsproduktes aus 3,4 mol 1,2-Naphthochinon-2-diazid-4-sulfonylchlorid und 1 mol Bis-(2,3,4-trihydroxy-5-benzoyl-phenyl)-methan, |
| 0,2 Gt | 2-(4-Styryl-phenyl)-4,6-bis-trichlormethyl-s-triazin, |
| 0,18 Gt | Victoriareinblau (C.I. 44 045), |
| 0,7 Gt | 4,4'-Dihydroxy-diphenylsulfon, |
| 0,1 G | eines Kieselgelfüllstoffs einer mittleren Korngröße von 4 µm, |
| 0,01 Gt | eines Dimethylsiloxan/Ethylenoxid/Propylenoxid-Copolymers und |
| ad 100 Gt | eines Lösemittelgemisches aus Tetrahydrofuran und γ-Butyrolacton (65:35), |

und bei 110 °C getrocknet, 50 s belichtet und 60 s mit einem Entwickler folgender Zusammensetzung entwickelt:

| | |
|---|---|
| 0,12 mol | Na₂Si₃O₇, |
| 0,48 mol | KOH, |
| 5 g | Natriumpelargonat, |
| 1 g | Nonylphenolpolyglykolether mit 10 Ethylenoxideinheiten, |
| 0,1 g | Siliconentschäumer (RC31 der Agfa-Gevaert AG) und |
| ad 1 l | mit VE-Wasser. |

Das Schichtgewicht betrug einheitlich 1,9 g/m² . Die Ergebnisse sind in Tabelle 4 zusammengestellt.

**Tabelle 4**

| **Beispiel** | **Polymer** | **LE** | **AV** | **UV** | **TD** | **DrA** |
|---|---|---|---|---|---|---|
| 2-1 | 2 | 3 | 1-12 | + | + | + |
| 2-2 | 3 | 4 | 1-12 | + | + | + |
| 2-3 | 4 | 6 | 1-12 | + | + | + |
| 2-4 | 15 | 5 | 1-12 | + | + | + |
| 2-5 | 20V | 5 | 1-12 | - | - | - |
| 2-6 | 22V | 6 | 1-12 | - | - | - |
| 2-7 | PF-Harz | 3 | 1-12 | - | + | - |

### Beispiel 3

Eine zunächst mechanisch, dann in Salzsäure elektrolytisch aufgerauhte (RZ-Wert nach DIN 4768 6,0 µm), in Schwefelsäure zwischengebeizte und anodisierte (Oxidgewicht 4,0 g/m²), mit Polyvinylphosphonsäure hydrophilierte Aluminiumfolie der Stärke 400 µm wurde mit folgender Lösung schleuderbeschichtet:

| | |
|---|---|
| 6,5 Gt | Bindemittel (vgl. Tabelle 5), |
| 2,3 Gt | eines Veresterungsproduktes aus 3,6 mol 1,2-Naphthochinon-2-diazid-5-sulfonylchlorid und 1 mol Bis-(2,3,4-trihydroxy-5-acetyl-phenyl)-methan, |
| 0,4 Gt | 1,2-Naphthochinon-2-diazid-4-sulfonylchlorid, |
| 0,5 Gt | 2,4-Dihydroxy-benzophenon, |
| 0,09 Gt | Kristallviolett-Base (C.I. 42 555:1), |
| ad 100 Gt | eines Lösemittelgemisches aus Aceton und N,N-Dimethyl-acetamid (70:30). |

und bei 110 °C getrocknet. Auf diese Kopierschicht wurde dann gemäß EP-A 0 649 063 als Mattierungsschicht eine anionisch stabilisierte Dispersion eines Methacrylsäure/Methylmethacrylat/Ethylacrylat-Copolymers mit einem Methacrylsäuregehalt von 6,1 Gew.-% elektrostatisch aufgesprüht, so daß eine mittlere Kalottenhöhe von 4 µm, ein mittlerer Kalottendurchmesser von 30 µm und eine Kalottendichte von ca. 2.000/cm² resultierte. Die Platten wurden wie Beispiel 1 belichtet und mit dem folgenden Entwickler 60 s lang entwickelt:

| | |
|---|---|
| 0,12 mol | Na₂Si₃O₇, |
| 0,48 mol | KOH, |
| 5 g | Natriumpelargonat, |
| 1 g | Nonylphenol-polyethylenglykolether mit etwa 10 Ethylenoxid-einheiten, |
| 0,1 g | Siliconentschäumer (RC31 der Agfa-Gevaert AG) und |
| ad 1 l | mit VE-Wasser. |

Die Prüfungsergebnisse sind in Tabelle 5 zusammengefaßt.

**Tabelle 5**

| **Beispiel** | **Polymer** | **SG** | **LE** | **AV** | **UV** | **TD** | **BrA** |
|---|---|---|---|---|---|---|---|
| 3-1 | 1 | 1,8 | 4 | 1-12 | + | + | + |
| 3-2 | 2 | 2,0 | 3 | 1-12 | + | + | + |
| 3-3 | 3 | 1,7 | 4 | 1-12 | + | + | + |
| 3-4 | 4 | 2,1 | 6 | 1-12 | + | + | + |
| 3-5 | 5 | 2,0 | 3 | 1-12 | + | + | + |
| 3-6 | 6 | 1,9 | 5 | 1-12 | + | + | + |
| 3-7 | 7 | 2,0 | 5 | 1-12 | + | + | + |
| 3-8 | 8 | 1,9 | 6 | 1-12 | + | + | + |
| 3-9 | 9 | 1,8 | 5 | 1-12 | + | + | + |
| 3-10 | 10 | 2,1 | 6 | 1-12 | + | + | + |
| 3-11 | 11 | 1,7 | 5 | 1-12 | + | + | + |
| 3-12 | 12 | 2,0 | 4 | 1-12 | + | + | + |
| 3-13 | 13 | 2,2 | 6 | 1-12 | + | + | + |
| 3-14 | 14 | 1,9 | 6 | 1-12 | + | + | + |
| 3-15V | 23 | 2,0 | 5 | 1-12 | - | - | - |
| 3-16V | 19 | 2,0 | 5 | 1-12 | 0 | - | 0 |
| 3-17V | 20 | 1,8 | 5 | 1-12 | + | - | + |
| 3-18V | 21 | 2,0 | 5 | 1-12 | 0 | + | 0 |
| 3-19V | 22 | 2,2 | 6 | 1-12 | - | - | - |
| 3-20V | PF-Harz | 2,0 | 6 | 1-12 | - | + | - |

### Beispiel 4

Eine in Salzsäure elektrolytisch aufgerauhte (RZ-Wert nach DIN 4768 6,0 µm), in Schwefelsäure anodisierte (Oxidgewicht 4,0 g/m²) und mit Polyvinylphosphonsäure hydrophilierte Aluminium-Platte der Stärke 300 µm wurde mit folgender Lösung schleuderbeschichtet:

| | |
|---|---|
| 4,7 Gt | Bindemittel (s. Tabelle 1), |
| 1,9 Gt | Polyacetal aus 2-Ethyl-butyraldehyd und Triethylenglykol, |
| 0,23 Gt | 2-(4-Styryl-phenyl)-4,6-bis-trichlormethyl-s-triazin, |
| 0,02 Gt | Kristallviolett und |
| ad 100 Gt | eines Lösemittelgemisches aus Butan-2-on und y-Butyrolacton (90:10) |

Die Platten wurden wie im Beispiel 1 beschrieben belichtet und in einer Lösung der nachstehenden Zusammensetzung 30 s lang entwickelt:

| | |
|---|---|
| 8,5 Gt | Na₂SiO₃ x 9 H₂O, |
| 0,8 Gt | NaOH, |
| 1,5 Gt | Na₂B₄O₇ x 12 H₂O und |
| ad 100 Gt | mit VE-Wasser |

Die Ergebnisse sind in Tabelle 6 zusammengestellt.

**Tabelle 6**

| **Beispiel** | **Polymer** | **SG** | **LE** | **AV** | **UV** | **TD** | **DrA** |
|---|---|---|---|---|---|---|---|
| 4-1 | 1 | 2,2 | 4 | 1-12 | + | + | + |
| 4-2 | 2 | 1,9 | 3 | 1-12 | + | + | + |
| 4-3 | 3 | 1,9 | 4 | 1-12 | + | + | + |
| 4-4 | 4 | 2,1 | 6 | 1-12 | + | + | + |
| 4-5 | 5 | 1,8 | 3 | 1-12 | + | + | + |
| 4-6 | 6 | 2,0 | 5 | 1-12 | + | + | + |
| 4-7 | 7 | 2,1 | 5 | 1-12 | + | + | + |
| 4-8 | 8 | 1,9 | 6 | 1-12 | + | + | + |
| 4-9 | 9 | 1,9 | 5 | 1-12 | + | + | + |
| 4-10 | 10 | 1,8 | 6 | 1-12 | + | + | + |
| 4-11 | 11 | 1,9 | 5 | 1-12 | + | + | + |
| 4-12 | 12 | 2,0 | 4 | 1-12 | + | + | + |
| 4-13 | 13 | 2;1 | 6 | 1-12 | + | + | + |
| 4-14V | 23 | 2,1 | 5 | 1-12 | 0 | - | 0 |
| 4-15V | 19 | 2,0 | 5 | 1-12 | 0 | - | - |
| 4-16V | 20 | 2,0 | 3 | 1-12 | + | - | + |
| 4-17V | 21 | 1,8 | 5 | 1-12 | 0 | + | 0 |
| 4-18V | 22 | 2,1 | 6 | 1-12 | - | - | - |
| 4-19V | PF-Harz | 2,0 | 6 | 1-12 | - | + | - |

### Beispiel 5

Eine zunächst mechanisch, dann in Salzsäure elektrolytisch aufgerauhte (RZ-Wert nach DIN 4768: 6,0 µm), in Schwefelsäure zwischengebeizte und anodisierte (Oxidgewicht: 4,0 g/m²), mit Polyvinylphosphonsäure hydrophilierte Aluminiumfolie der Stärke 400 um wurde mit folgender Dispersion schleuderbeschichtet:

| | |
|---|---|
| 9,7 Gt | Bindemittel (vgl. Tabelle 6), |
| 0,8 Gt | Poly(4-Hydroxy-styrol) mit einem M_{w} von 4.000 bis 6.000 und einem Mₙ von 2.100 bis 3.100 (® Maruka Lyncur M, Typ S-2, von Maruzen Petrochemical Co., Ltd.), |
| 8,0 Gt | Rußdispersion der im folgenden angegebenen Zusammensetzung, |
| 40 Gt | Propylenglykol-monomethylether, |
| 31 Gt | Aceton und |
| 10,5 Gt | γ-Butyrolacton |

Dabei bestand die Rußdispersion aus

| | |
|---|---|
| 5,00 Gt | Ruß (Spezialschwarz 250 der Degussa AG), |
| 66,00 Gt | des Bindemittels (30% in γ-Butyrolacton), |
| 28,99 Gt | γ-Butyrolacton und |
| 0,01 Gt | Siliconentschäumer (RC31 der Agfa-Gevaert AG). |

Die thermische Bebilderung erfolgte dann mit einer digitalen Rastervorlage in einem Außentrommelbelichter mit einer IR-Laserdiodenleiste (Emissionsmaximum: 830 nm; Leistung jeder einzelnen Diode 40 mW, Schreibgeschwindigkeit: 1 m/s; Strahlbreite: 10 µm). Es wurde eine Bestrahlungsenergie von 250mJ/cm² aufgewendet. Die Platten wurden 60 s lang mit folgender Lösung entwickelt:

| | |
|---|---|
| 0,45 mol/l | K₂SiO₃, |
| 10 g | Natriumcumolsulfonat, |
| 1 g | Polyglykol-1000-dicarbonsäure, |
| 0,1 g | Propylendiamintetraacetat und |
| ad 1 l | mit VE-Wasser. |

Der Restschleier (RS) der Schicht wurde optisch bewertet gegenüber einem mit Korrekturmittel KP 273 der Agfa-Gevaert AG entschichteten Träger (+: kein Restschleier; -: Restschleier).

**Tabelle 7**

| **Beispiel** | **Polymer** | **SG** | **RS** | **AV** | **UV** | **TD** | **DrA** |
|---|---|---|---|---|---|---|---|
| 5-1 | 1 | 2,2 | + | 2-98 | + | + | + |
| 5-2 | 2 | 1,9 | + | 2-98 | + | + | + |
| 5-3 | 3 | 1,9 | + | 2-98 | + | + | + |
| 5-4 | 4 | 2,0 | + | 2-98 | + | + | + |
| 5-5 | 5 | 1,9 | + | 2-98 | + | + | + |
| 5-6 | 6 | 2,1 | + | 2-98 | + | + | + |
| 5-7 | 7 | 2,1 | + | 2-98 | + | + | + |
| 5-8 | 8 | 1,9 | + | 2-98 | + | + | + |
| 5-9 | 9 | 1,9 | + | 2-98 | + | + | + |
| 5-10 | 10 | 2,0 | + | 2-98 | + | + | + |
| 5-11 | 11 | 1,9 | + | 2-98 | + | + | + |
| 5-12 | 12 | 2,1 | + | 2-98 | + | + | + |
| 5-13 | 13 | 2,0 | + | 2-98 | + | + | + |
| 5-14 | 17 | 2,2 | + | 2-98 | + | + | + |
| 5-15 | 15 | 1,9 | + | 2-98 | + | + | + |
| 5-16 | 16 | 2,0 | + | 2-98 | + | + | + |
| 5-17V | 23 | 2,1 | + | 2-98 | 0 | - | - |
| 5-18V | 19 | 1,9 | + | 2-98 | 0 | - | 0 |
| 5-19V | 20 | 1,9 | - | 2-98 | + | - | + |
| 5-20V | 21 | 2,0 | - | 2-98 | 0 | + | 0 |
| 5-21V | 22 | 2,0 | + | 2-98 | - | - | - |
| 5-22V | PF-Harz | 2,2 | + | 2-98 | - | + | - |

### Beispiel 6

Eine in Salpetersäure elektrolytisch aufgerauhte (RZ-Wert nach DIN 4768: 6,0 µm), in Schwefelsäure zwischengebeizte und anodisierte (Oxidgewicht: 2,0 g/m²), mit Polyvinylphosphonsäure hydrophilierte Aluminiumfolie der Stärke 400 µm wurde mit folgender Lösung

| | |
|---|---|
| 62 Gt | Bindemittel (vgl. Tabelle 8), |
| 21 Gt | eines Diazoniumpolykondensationsprodukts, hergestellt aus 1 mol 3-Methoxy-diphenylamin-4-diazoniumsulfat und 1 mol 4,4'-Bis-methoxymethyl-diphenylether in 85%iger Phosphorsäure, isoliert als Mesitylensulfonat, |
| 2,5 Gt | Phosphorsäure, |
| 3 Gt | Viktoriareinblau FGA (C.l. Basic Blue 81), |
| 0,7 Gt | Phenylazodiphenylamin in |
| 2570 Gt | Ethylenglykol-monomethylether und |
| 780 Gt | γ-Butyrolacton, |

schleuderbeschichtet, anschließend 30 s belichtet und 30 s lang in einer Küvette mit folgender Lösung entwickelt:

| | |
|---|---|
| 5,0 Gt | Natriumoctylsulfat, |
| 1,5 Gt | Natriummetasilikat x 5 H₂O, |
| 1,0 Gt | Trinatriumphosphat x 12 H₂O, |
| 0,5 Gt | Dinatriumhydrogenphosphat x 12 H₂O, |
| 92,0 Gt | VE-Wasser. |

- AE =: Aufentwickelbarkeit, die anhand der schleierfreien Entwicklung der Nichtbildstellen beurteilt wurde :
+ = schleierfreie Entwicklung,
- = Restschleier/Schichtreste.
- IPRO =: Stabilität gegen Isopropanol: Die belichteten und entwickelten Platten wurden 60 s lang in einer Küvette Isopropanol ausgesetzt; anschließend wurde die Bildschädigung gravimetrisch beurteilt:
+ = Schichtabtrag geringer 10%, schwacher Angriff;
0 = Schichtabtrag zwischen 10 und 30%, mittlerer Angriff;
- = Schichtabtrag größer 30% starker Angriff oder vollständiger Schichtabtrag.
- DrA =: + = Druckauflage mehr als 200.000,
o = Druckauflage 150.000 bis 200.000,
- = Druckauflage weniger als 150.000.

**Tabelle 8**

| **Beispiel** | **Polymer** | **SG** | **AE** | **AV** | **IPRO** | **DrA** |
|---|---|---|---|---|---|---|
| 6-1 | 3 | 0,9 | + | 1-12 | + | + |
| 6-2 | 8 | 0,8 | + | 1-12 | + | + |
| 6-3 | 9 | 0,9 | + | 1-12 | + | + |
| 6-4 | 10 | 0,9 | + | 1-12 | + | + |
| 6-5 | 13 | 1,0 | + | 1-12 | + | + |
| 6-6 | 18 | 1,0 | + | 1-12 | + | + |
| 6-7V | 23 | 1,1 | + | 1-12 | 0 | 0 |
| 6-8V | 21 | 1,1 | + | 1-12 | 0 | - |
| 6-9V | 22 | 1,1 | - | 2-12 | 0 | - |
| 6-10V | PVB* | 1,0 | + | 1-12 | 0 | 0 |

| | | | | | | |
|---|---|---|---|---|---|---|
| * = mit Maleinsäureanhydrid funktionalisiertes Polyvinylbutyral mit einem Molekulargewicht M_{w} von ca. 80.000, das 71% Vinylbutyral-, 2% Vinylacetat- und 27% Vinylalkoholeinheiten enthält. | | | | | | |

### Beispiel 7

Eine in Salzsäure elektrolytisch aufgerauhte (RZ-Wert nach DIN 4768: 6,0 µm), in Schwefelsäure zwischengebeizte und anodisierte (Oxidgewicht: 3,0 g/m²), mit Polyvinyl-phosphonsäure hydrophilierte Aluminiumfolie der Stärke 400 µm wurde mit folgender Dispersion

| | |
|---|---|
| 2,84 Gt | Bindemittel (vgl. Tabelle 9), |
| 1,40 Gt | des Umsetzungsprodukts von 1 mol Triethanolamin mit 3 mol Isocyanatoethylmethacrylat, |
| 0,04 Gt | Orasolblau (C.I. 50315), |
| 0,04 Gt | Eosin alkohollöslich (C.I. 45386), |
| 0,03 Gt | 2,4-Bis-trichlormethyl-6-(4-styryl-phenyl)-s-triazin und |
| 0,06 Gt | Di-cyclopentadienyl-bis-pentafluorphenyl-titan in |
| 11,0 Gt | Butanon, |
| 7,0 Gt | Butylacetat und |
| 4,0 Gt | γ-Butyrolacton |

schleuderbeschichtet, getrocknet und mit einer 15 %igen Lösung von Polyvinylalkohol (12% Restacetylgruppen, K-Wert: 4) so beschichtet. daß ein Schichtgewicht der Deckschicht zwischen 2,5 und 4 g/cm² resultierte. Die erhaltene Druckplatte wurde mit einer 2 kW-Metallhalogenidlampe im Abstand von 110 cm unter einem Belichtungskeil "BK 02" der Agfa-Gevaert AG für 20 Sekunden belichtet, wobei auf den Keil zusätzlich ein Silberfilm mit gleichmäßiger Schwärzung (Dichte 1,4) und gleichmäßiger Absorption über den wirksamen Spektralbereich als Graufilter montiert war. Nach der Belichtung wurde die Platte eine Minute lamg auf 100°C erwärmt. Anschließend wurde die Platte 30 s lang in einem Entwickler der folgenden Zusammensetzung entwickelt:

| | |
|---|---|
| 120 Gt | Natriummetasilikat x 9 H₂O, |
| 2,13 Gt | Strontiumchlorid, |
| 1,2 Gt | nichtionogenes Netzmittel (Kokosfettalkohol-polyoxyethylenether mit ca. 8 Ethylenglykol-Einheiten) und |
| 0,12 Gt | Antischaummittel in |
| 4000 Gt | VE-Wasser |

**Tabelle 9**

| **Beispiel** | **Polymer** | **SG** | **AE** | **AV** | **IPRO** | **DrA**** |
|---|---|---|---|---|---|---|
| 7-1 | 3 | 0,8 | + | 1-12 | + | + |
| 7-2 | 8 | 0,9 | + | 1-12 | + | + |
| 7-3 | 9 | 1,0 | + | 1-12 | + | + |
| 7-4 | 11 | 0,9 | + | 1-12 | + | + |
| 7-5 | 13 | 1,0 | + | 1-12 | + | + |
| 7-6 | 15 | 1,1 | + | 1-12 | + | + |
| 7-7 | 18 | 0,9 | + | 1-12 | + | + |
| 7-8V | 23 | 1,1 | + | 1-12 | 0 | 0 |
| 7-9V | 20 | 1,2 | - | 3-12 | + | - |
| 7-10V | 22 | 1,1 | - | 2-12 | 0 | - |
| 7-11V | PA* | 1,2 | + | 1-12 | 0 | 0 |

| | | | | | | |
|---|---|---|---|---|---|---|
| *Terpolymer aus Methylmethacrylat/Ethylacrylat/Methacrylsäure im Verhältnis 60:25:15 | | | | | | |
| **Druckauflage: + = >150 000; 0 = 100 000 bis 150 000; - = Druckauflage < 100 000. | | | | | | |

### Beispiel 8

Eine mit einer Suspension aus gemahlenem Bimsstein aufgerauhte, in Schwefelsäure eloxierte, mit Polyvinylphosphonsäure hydrophilierte Aluminiumfolie der Stärke 150 µm wurde mit folgender Lösung

| | |
|---|---|
| 6,5 Gt | Bindemittel (vgl. Tabelle 10), |
| 4,0 Gt | 2,5-Bis-(4-diethylamino-phenyl)-[1,3,4]oxadiazol, |
| 0,02 Gt | Rhodamin FB (C.I. 45170) und |
| 0,02 Gt | Acriflavin in |
| 45 Gt | Aceton und |
| 45 Gt | γ-Butyrolacton |

schleuderbeschichtet, getrocknet und anschließend im Dunkeln mit einer Kamera EA 693 der Agfa-Gevaert AG mittels einer Corona auf -550 V aufgeladen, in Projektion mit 8 Halogenlampen a 500 W 15 Sekunden im Auflicht unter einer Positivkopiervorlage (Belichtungskeil "BK 02" der Agfa-Gevaert AG) belichtet, das entstandene latente Ladungsbild mit Hilfe einer Magnetbürste mit einem Toner/Carrier-Gemisch (Toner auf Basis eines Styrol/Butylacrylat-Copolymers mit Ladungssteuermittel auf Fettsäurebasis und angefärbt mit Ruß, mittlerer Teilchendurchmesser ca. 10 µm, Carrier auf Eisenbasis mit einer mittleren Teilchengröße von ca. 100 µm, Mischungsverhältnis 2:98) bei einer Gegenspannung von 150 V betonert und nach einer Wärmefixierung des schwarzen Toners bei 130°C in einem Entschichtungsgerät (EG 659 der Agfa-Gevaert AG) bei einer Verarbeitungsgeschwindigkeit von 1,5 m/min (entsprechend ca. 15 s Einwirkzeit) und 26°C mit folgender Lösung entschichtet:

| | |
|---|---|
| 10 Gt | Ethanolamin, |
| 10 Gt | Phenylpolyglykol, |
| 2 Gt | Dikaliumhydrogenphosphat, |
| 78 Gt | VE-Wasser. |

Die Ergebnisse in Tabelle 9 resultieren aus folgender Beurteilung: Aufentwickelbarkeit (AE) anhand der schleierfreien Entschichtung nach 5 Sekunden der Nichtbildstellen (+ = schleierfreie Entwicklung; - = Restschleier/Schichtreste) und Wiedergabe (AV) anhand der einheitlichen Flächendeckung des Tonerbildes (+ = einheitliche Betonerung; - = Streifenbildung oder ähnliche Störungen). Die Definition der Druckauflage entspricht den Angaben in Tabelle 8.

**Tabelle 10:**

| **Beispiel** | **Polymer** | **AE** | **AV** | **DrA** |
|---|---|---|---|---|
| 8-1 | 2 | + | + | + |
| 8-2 | 4 | + | + | + |
| 8-3 | 6 | + | + | + |
| 8-4 | 10 | + | + | + |
| 8-5 | 11 | + | + | + |
| 8-6 | 13 | + | + | + |
| 8-7 | 16 | + | + | + |
| 8-8 V | 19 | + | + | 0 |
| 8-9 V | 20 | - | - | - |
| 8-10V | 22 | + | - | - |
| 8-11V | PS/MSA* | + | + | + |

| | | | | |
|---|---|---|---|---|
| *alternierendes Copolymer aus Styrol und Maleinsäureanhydrid | | | | |

## Patentansprüche

1. Positiv oder negativ arbeitendes strahtungsempfindliches Gemisch, das a) ein in Wasser unlösliches, in wäßrig-alkalischen Lösungen dagegen lösliches oder zumindest quellbares polymeres Bindemittel und b) mindestens eine strahlungsempfindliche Verbindung enthält, **dadurch gekennzeichnet, daß** das Bindemittel ein Polymer
mit Einheiten der Formel I 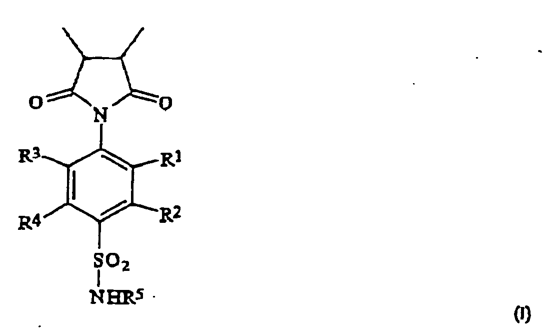 umfasst, worin
R¹, R², und R⁴ gleich oder verschieden sind und für ein Wasserstoff- oder Halogenatom, eine Hydroxy- oder Alkoxygruppe, eine unsubstituierte oder substituierte Alkyl- oder Arylgruppe stehen,
R⁵ ein Wasserstoffatom, eine Alkyl- oder Alkanoylgruppe, eine Gruppe der Formel C(=NH)-NHR¹, einen iso- oder heterocyclischen, gesättigten oder ungesättigten, unsubstituierten oder substituierten Rest mit 1 bis 20 C-Atomen, die untereinander zu einem mono- oder bicyclischen Ringsystem mit mindestens 3 C-Atomen verknüpft sein können, darstellt.

2. Gemisch gemäß Anspruch 1, **dadurch gekennzeichnet, daß** der Anteil des Polymers mit Einheiten der Formel (I) 10 bis 95 Gew.-%, bevorzugt 30 bis 80 Ges.-%, jeweils bezogen auf das Gesamtgewicht der nichtflüchtigen Bestandteile des Gemisches, beträgt.

3. Gemisch gemäß Anspruch 1, **dadurch gekennzeichnet, daß** die strahlungsempfindliche Verbindung eine 1,2-Chinondiazidverbindung, bevorzugt ein 1,2-Naphthochinon-2-diazid-4- oder -5-sulfonsäureester oder -amid, ist.

4. Gemisch gemäß Anspruch 3, **dadurch gekennzeichnet, daß** der Anteil der 1,2-Chinondiazidverbindung 3 bis 50 Gew.-%, bevorzugt 7 bis 35 Gew.-%, jeweils bezogen auf das Gesamtgewicht der nichtflüchtigen Bestandteile des Gemisches, beträgt.

5. Gemisch gemäß einem der vorstehenden Ansprüche, **dadurch gekennzeichnet, daß** R¹, R², R³ und R⁴ jeweils für ein Wasserstoffatom stehen.

6. Gemisch gemäß einem der vorstehenden Ansprüche, **dadurch gekennzeichnet, daß** das polymere Bindemittel ein Copolymer ist.

7. Gemisch gemäß Anspruch 6, **dadurch gekennzeichnet, daß** das Copolymer neben Einheiten der Formel I auch Einheiten mit aromatischen Gruppen enthält.

8. Gemisch gemäß Anspruch 7, **dadurch gekennzeichnet, daß** der Anteil der Einheiten der Formel I 10 bis 90 mol-%, bevorzugt 25 bis 65 mol-%, beträgt.

9. Gemisch gemäß einem der vorstehenden Ansprüche, **dadurch gekennzeichnet, daß** sein Molekulargewicht M_{w} 1.000 bis 100.000, bevorzugt 5.000 bis 50.000, beträgt.

10. Strahlungsempfindliches Aufzeichnungsmaterial mit einem Schichtträger mit einer strahlungsempfindlichen Schicht, **dadurch gekennzeichnet, daß** die Schicht ein Gemisch gemäß einem der vorstehenden Ansprüche enthält.

11. Verfahren zur Herstellung von chemikalienbeständigen Reliefaukeichnungen, bei dem ein strahlungsempfindliches Aufzeichnungsmaterial gemäß Anspruch 10 mit einem Träger und einer strahlungsempfindlichen Schicht bildmäßig belichtet und anschließend mit einer wäßrig-alkalischen Lösung entwickelt wird.

## Claims

1. A positive or negative working, radiation-sensitive mixture which comprises a) a polymeric binder which is insoluble in water, but soluble or at least swellable in aqueous-alkaline solutions, and b) at least one radiation-sensitive compound, wherein the binder comprises a polymer containing units corresponding to the formula I 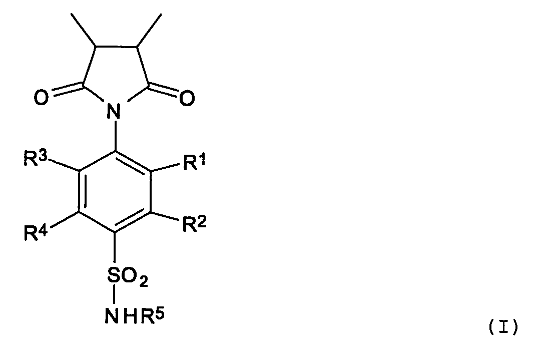 wherein
R¹, R², R³ and R⁴ same or different, represent a hydrogen or halogen atom, a hydroxyl or alkoxy group, an unsubstituted or substituted alkyl or aryl group, and
R⁵ represents a hydrogen atom, an alkyl or alkanoyl group, a group of the formula C(=NH)-NH-R¹ or an iso- or heterocyclic, saturated or unsaturated, unsubstituted or substituted radical having 1 to 20 carbon atoms which may be linked to one another to form a monocyclic or bicyclic ring system having at least 3 carbon atoms.

2. The mixture according to claim 1, wherein the proportion of the polymer containing units of the formula (I) is from 10 to 95% by weight, preferably from 30 to 80% by weight, in each case based on the total weight of the nonvolatile matter of the mixture.

3. The mixture according to claim 1, wherein the radiation-sensitive compound is a 1,2-quinone diazide compound, preferably a 2-diazo-1,2-naphthoquinone-4- or -5-sulfonic ester or -sulfonamide.

4. The mixture according to claim 3, wherein the proportion of the 1,2-quinone diazide compound is from 3 to 50% by weight, preferably from 7 to 35% by weight, in each case based on the total weight of the nonvolatile matter of the mixture.

5. The mixture according to anyone of the preceding claims, wherein each of R¹, R², R³ and R⁴ represents a hydrogen atom.

6. The mixture according to anyone of the preceding claims, wherein the polymeric binder is a copolymer.

7. The mixture according to claim 6, wherein, besides units of the formula I, the copolymer also contains units containing aromatic groups.

8. The mixture according to claim 7, wherein the proportion of units of the formula I is from 10 to 90 mol%, preferably from 25 to 65 mol%.

9. The mixture according to anyone of the preceding claims, having a molecular weight M_{w} of from 1000 to 100,000, preferably from 5000 to 50,000.

10. A radiation-sensitive recording material comprising a support having a radiation-sensitive coating, wherein the coating comprises a mixture as defined in anyone of the preceding claims.

11. A process for the production of chemical-resistant relief recordings, in which a radiation-sensitive recording material as defined in claim 10 having a support and a radiation-sensitive coating is exposed imagewise and then developed with an aqueous-alkaline solution.

## Revendications

1. Composition sensible au rayonnement à traitement positif ou négatif, qui contient a) un liant polymère insoluble dans l'eau, par contre soluble ou au moins apte à gonfler dans des solutions alcalines-aqueuses et b) au moins un composé photosensible, **caractérisée en ce que** le liant contient un polymère comprenant des unités répondant à la formule I 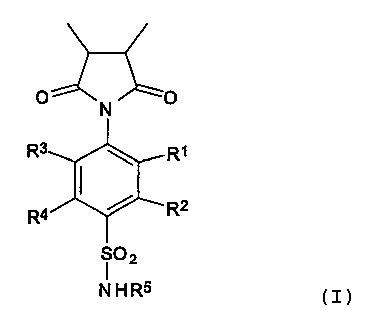 dans laquelle
R¹, R², R³ et R⁴ sont identiques ou différents et représentent un atome d'hydrogène ou un atome d'halogène, un groupe hydroxyle ou un groupe alcoxy, un groupe alkyle ou un groupe aryle non substitué ou substitué ;
R⁵ représente un atome d'hydrogène, un groupe alkyle ou un groupe alcanoyle, un groupe répondant à la formule C(=NH)-NH-R¹, un radical isocyclique ou hétérocyclique, saturé ou insaturé, non substitué ou substitué, contenant de 1 à 20 atomes de carbone qui peuvent être reliés les uns aux autres pour former un système à noyau monocyclique ou bicyclique comprenant au moins 3 atomes de carbone.

2. Composition selon la revendication 1, **caractérisée en ce que** la fraction du polymère comprenant des unités répondant à la formule (I) s'élève de 10 à 95 % en poids, de préférence de 30 à 80 % en poids, chaque fois rapportés au poids total des constituants non volatils de la composition.

3. Composition selon la revendication 1, **caractérisée en ce que** le composé sensible au rayonnement représente un composé de 1,2-quinonediazide, de préférence un ester ou un amide de l'acide 1,2-naphtoquinone-2-diazide-4- ou 5-sulfonique.

4. Composition selon la revendication 3, **caractérisée en ce que** la fraction du composé de 1,2-quinonediazide s'élève de 3 à 50 % en poids, de préférence de 7 à 35 % en poids, chaque fois rapportés au poids total des constituants non volatils de la composition.

5. Composition selon l'une quelconque des revendications précédentes, **caractérisée en ce que** R¹, R², R³ et R⁴ représentent respectivement un atome d'hydrogène.

6. Composition selon l'une quelconque des revendications précédentes, **caractérisée en ce que** le liant polymère est un copolymère.

7. Composition selon la revendication 6, **caractérisé en ce que** le copolymère contient, en plus des unités répondant à la formule I, également des unités comprenant des groupes aromatiques.

8. Composition selon la revendication 7, **caractérisée en ce que** la fraction des unités répondant à la formule I s'élève de 10 à 90 mol %, de préférence de 25 à 65 mol %.

9. Composition selon l'une quelconque des revendications précédentes, **caractérisée en ce que** son poids moléculaire M_{w} s'élève de 1000 à 100.000, de préférence de 5000 à 50.000.

10. Matériau d'enregistrement sensible au rayonnement, comprenant un support de couche comprenant une couche sensible au rayonnement, **caractérisé en ce que** la couche contient une composition selon l'une quelconque des revendications précédentes.

11. Procédé pour la préparation d'enregistrements en relief résistant aux produits chimiques, dans lequel on expose en forme d'image un matériau d'enregistrement sensible au rayonnement selon la revendication 10 comprenant un support et une couche sensible au rayonnement, et on le développe ensuite avec une solution alcaline-aqueuse.
